# EUROPÄISCHE PATENTSCHRIFT

(11) **EP 2 195 865 B1**
(45) Veröffentlichungstag und Bekanntmachung des Hinweises auf die Patenterteilung: **14.03.2018**
(21) Anmeldenummer: 08801325.5
(22) Anmeldetag: 12.09.2008
(51) Int. Cl.: H01L 33/48, H01L 33/50, H01L 33/58

(54) **STRAHLUNGSEMITTIERENDES HALBLEITERBAUELEMENT UND VERFAHREN ZUR HERSTELLUNG EINES STRAHLUNGSEMITTIERENDEN HALBLEITERBAUELEMENTS**
RADIATION-EMITTING SEMI-CONDUCTOR COMPONENT AND METHOD FOR PRODUCING A RADIATION-EMITTING SEMICONDUCTOR COMPONENT
COMPOSANT SEMI-CONDUCTEUR ÉMETTANT DU RAYONNEMENT ET PROCÉDÉ DE FABRICATION D'UN TEL COMPOSANT

(30) Priorität: 28.09.2007 DE 102007046744; 21.01.2008 DE 102008005345
(43) Veröffentlichungstag der Anmeldung: 16.06.2010
(73) Patentinhaber: OSRAM Opto Semiconductors GmbH, 93055 Regensburg (DE)
(72) Erfinder: SORG, Jörg, 93053 Regensburg (DE); GRUBER, Stefan, 93077 Bad Abbach (DE)
(74) Vertreter: Epping - Hermann - Fischer
(86) Internationale Anmeldenummer: PCT/DE2008/001533
(87) Internationale Veröffentlichungsnummer: WO 2009/039829

(56) Entgegenhaltungen:
- EP-A- 1 115 155
- EP-A- 1 119 058
- EP-A1- 1 603 170
- EP-A1- 2 666 745
- EP-A2- 1 267 420
- WO-A-2006/117710
- DE-A1- 10 308 890
- DE-C1- 19 600 306
- JP-A- 2005 072 129
- US-A1- 2007 064 131

## Beschreibung

Die vorliegende Anmeldung betrifft ein halbleiterbasiertes Bauelement mit strahlungsemittierenden Eigenschaften, einTrägersubstrat für ein halbleiterbasiertes Bauelement und ein Verfahren zur Herstellung eines halbleiterbasierten Bauelements.

In der Druckschrift EP 1 119 058 A1 ist eine Leuchtdiode angegeben, bei der ein Leuchtdiodenchip in einem Hohlraum an einer Glasabdeckung angeordnet ist.

Die Druckschrift DE 196 00 306 C1 beschreibt eine Leuchtdiode mit einem Halbleiterchip, der auf einem Glasträger befestigt in einem Hohlraum einer Elektrodenanschlussplatte angeordnet ist, auf der Lötpolster zur Kontaktierung galvanisch aufgebracht werden.

Die Druckschrift EP 1 267 420 A2 offenbart in den Figuren 10 und 11 jeweils ein LED-Bauelement, bei dem ein LED-Chip in einem Hohlraum einer Glaslinse angeordnet ist. Kontaktflächen an der der Glaslinse abgewandten Seite des LED-Chips liegen frei. Ein Montagesockel wird durch den Teil der Glaslinse gebildet, der den LED-Chip seitlich umgibt, wobei der Montagesockel eine Materialstärke aufweist, die der Gesamtdicke des LED-Chips gleicht.

Halbleiterbasierte Bauelemente mit strahlungsemittierenden Eigenschaften, wie zum Beispiel Leuchtdioden, sind zumeist so gebildet, dass in ein Gehäuse aus einem Kunststoffmetallverbund oder in ein Gehäuse aus Keramik ein Halbleiterelement mit strahlungsemittierenden Eigenschaften montiert oder eingebettet ist. Während eines Produktionsprozesses eines derartigen halbleiterbasierten Bauelementes erfolgt die Montage des Halbleiterelements in dem Gehäuse mittels eines Lötvorgangs oder eines Klebeprozesses.

Halbleiterelemente mit strahlungsemittierenden Eigenschaften wie zum Beispiel Dünnfilm-Leucht-Dioden können unterschieden werden in vertikal von Strom durchflossene Halbleiterelemente oder horizontal von Strom durchflossene Halbleiterelemente. Bei Halbleiterelementen, welche in vertikaler Richtung von Strom durchflossen sind, ist die Montagefläche des halbleiterbasierten Bauelements als ein einzelner elektrischer Kontakt ausgebildet. Ein zweiter elektrischer Kontakt ist auf der strahlungsemittierenden Seite des Halbleiterelementes angeordnet. Dieser Kontakt wird üblicherweise mit einem Bonddraht kontaktiert. Halbleiterelemente mit horizontalem Stromfluss sind derart ausgebildet, dass auf der Montagefläche des Halbleiterelementes zwei elektrische Kontakte ausgebildet sind.

Insbesondere folgen bei einem vertikal von Strom durchflossenen Halbleiterelement der erste und der zweite elektrische Kontakt in Richtung einer Flächennormalen einer Haupterstreckungsebene des Halbleiterelements aufeinander. Bei einem horizontal von Strom durchflossenen Halbleiterelement sind der erste und der zweite elektrische Kontakt oder Bereiche des ersten und zweiten elektrischen Kontakts in Draufsicht auf die Haupterstreckungsebene nebeneinander angeordnet.

Zweckmäßigerweise ist der Stromfluss insbesondere nicht ausschließlich vertikal oder horizontal. Vielmehr findet bei vertikal stromdurchflossenen Halbleiterelementen vorzugweise eine laterale Stromaufweitung statt. Bei horizontal stromdurchflossenen Halbleiterelementen hat der Stromfluss innerhalb des Halbleiterelements insbesondere zumindest stellenweise eine zur Flächennormalen auf die Haupterstreckungsebene parallele Komponente.

Unabhängig von der Bauweise des Halbleiterelements selbst wird in dem Gehäuse durch Vergießen mit einem transparenten Harz oder einem anderen Einkapselungsmaterial das Halbleiterelement zusätzlich von äußeren Einflüssen geschützt. Eine statische Stabilität und ein Schutz vor mechanischer Belastung des Halbleiterelements erfolgt durch das Gehäuse, welches das Halbleiterelement schützend und tragend umgibt. Durch das ummantelnde Gehäuse ergibt sich für das Strahlungsemittierende halbleiterbasierte Bauelement eine Baugröße, welche die Größe des Halbleiterelementes selbst, weit überschreitet. Dies steht einer weiteren möglichen Miniaturisierung der Bauelemente entgegen.

Es ist demzufolge die Aufgabe der Erfindung ein halbleiterbasiertes Bauelement mit strahlungsemittierenden Eigenschaften anzugeben, das eine weitere Miniaturisierung ermöglicht. Diese Aufgabe wird durch ein Bauelement und ein Verfahren gemäß den Ansprüchen 1 und 13 gelöst. Vorteilhafte Ausgestaltungen und Weiterbildungen sind in den jeweils abhängigen Patentansprüchen angegeben. Der Offenbarungsgehalt der Patentansprüche wird hiermit ausdrücklich durch Rückbezug in die Beschreibung aufgenommen.

Es wird ein halbleiterbasiertes Bauelement zur Montage auf einem Trägersubstrat angegeben. Das Bauelement umfasst ein Glassubstrat, welches eine erste Oberfläche und eine zweite Oberfläche, die der ersten Oberfläche gegenüber liegt, aufweist. Ein Halbleiterelement mit strahlungsemittierenden Eigenschaften ist auf der ersten Oberfläche angeordnet. Das Halbleiterelement weist zumindest zwei elektrisch leitende Kontaktflächen an der von der ersten Oberfläche des Glassubstrats abgewandten Seite auf. Eine Mehrzahl von galvanisch aufgebrachten Montagesockeln befindet sich auf dem Randbereich der ersten Oberfläche des Glassubstrats. Die Kontaktflächen sind so eingerichtet, dass sie durch Kleben mit einem leitfähigen Klebstoff oder durch Löten mit Kontakten des Trägersubstrats elektrisch leitend verbindbar sind. Die Montagesockel sind von den Kontaktflächen verschieden und weisen eine Materialstärke auf, welche der Gesamtdicke des Halbleiterelements gleicht, sodass die Montagesockel das Bauelement im unmontierten Zustand vor abrasiver Belastung schützen und im montierten Zustand mechanische Belastungen aufnehmen und an das Trägersubstrat ableiten können. Die Kontaktflächen liegen im unmontierten Zustand frei.

Das Glassubstrat weist im Wesentlichen zwei Oberflächen auf, die einander gegenüberliegend und insbesondere zueinander parallel angeordnet sind. Auf einer ersten Oberfläche des Glassubstrates ist ein Halbleiterelement angeordnet, welches strahlungsemittierende Eigenschaften aufweist. Das Halbleiterelement ist auf dieser Oberfläche so angeordnet, dass die Strahlungsrichtung zum Glassubstrat hin und weiter in dieses hinein gerichtet ist. Unter der Strahlungsrichtung wird vorliegend insbesondere eine zu einer Haupterstreckungsebene des Halbleiterelements senkrechte Richtung verstanden, in welche das Halbleiterelement im Betrieb elektromagnetische Strahlung emittiert. Vorteilhaft ist, dass das Glassubstrat ein tragendes Element für das Halbleiterelement bildet.

Bei einer Ausgestaltung hat das halbleiterbasierte Bauelement eine im Wesentlichen quadratische Grundform. Bei einer Weiterbildung hat es eine Kantenlänge von im Wesentlichen 3 mm. Bei einer anderen Ausgestaltung hat es eine Dicke von im Wesentlichen 0,85 mm. Bei einer weiteren Ausgestaltung sind die lateralen Abmessungen des Bauelements gleich den lateralen Abmessungen des Glassubstrats.

Bei einer Ausgestaltung ist das Halbleiterelement als Dünnfilm-Leuchtdiode ausgebildet. Für Halbleiterelemente mit horizontalem Stromfluss, insbesondere für Dünnfilm-Leucht-Dioden, bildet das Glassubstrat als tragendes Element einen wesentlichen Vorteil, da im besonderen bei Dünnfilm-Leucht-Dioden während des Produktionsprozesses ein Aufwachssubstrat abgetrennt wird. Dieses Aufwachssubstrat bildet während des Produktionsprozesses das tragende Element für diese Halbleiterelemente. Durch das Abtrennen des Aufwachssubstrates während des Produktionsprozesses sind alternative Elemente erforderlich, welche tragende Eigenschaften aufweisen. Das Glassubstrat bietet nicht nur tragende Eigenschaften, sondern schützt das Halbleiterelement vor mechanischer Belastung. Ein Grundprinzip einer Dünnfilm-Leucht-Diode ist beispielsweise in der Druckschrift I. Schnitzer et al., Appl. Phys. Lett. 63 (16) 18. Oktober 1993, Seiten 2174 - 2176 beschrieben. Beispiele für Dünnfilm-Leuchtdiodenchips sind in den Druckschriften EP 0905797 A2 und WO 02/13281 A1 beschrieben. Die Dünnfilm-Leuchtdiode weist - ohne das Glassubstrat - bei einer Ausgestaltung eine Dicke im Bereich von 20 µm oder weniger, insbesondere im Bereich von 10 µm oder weniger auf; Vorzugsweise ist sie frei von einem Aufwachssubstrat. Vorliegend bedeutet "frei von einem Aufwachssubstrat, dass ein gegebenenfalls zum Aufwachsen einer Halbleiterschichtenfolge der Dünnfilm-Leuchtdiode benutztes Aufwachssubstrat von der Halbleiterschichtenfolge entfernt oder zumindest stark gedünnt ist. Insbesondere ist es derart gedünnt, dass es für sich oder zusammen mit der Halbleiterschichtenfolge alleine nicht freitragend ist. Der verbleibende Rest des stark gedünnten Aufwachssubstrats ist insbesondere als solches für die Funktion eines Aufwachssubstrates ungeeignet; und Bei einer Ausgestaltung enthält die Dünnfilm-Leuchtdiode mindestens eine Halbleiterschicht mit zumindest einer Fläche, die eine Durchmischungsstruktur aufweist, die im Idealfall zu einer annähernd ergodischen Verteilung des Lichtes in der Halbleiterschichtenfolge führt, das heißt, sie weist ein möglichst ergodisch stochastisches Streuverhalten auf.

Bei einer anderen Ausgestaltung ist an einer von dem Glassubstrat abgewandten Hauptfläche einer strahlungserzeugenden Halbleiterschichtenfolge der Dünnfilm-Leuchtdiode, bei der es sich insbesondere um eine strahlungserzeugende Epitaxie-Schichtenfolge handelt, eine reflektierende Schicht aufgebracht oder ausgebildet, die zumindest einen Teil der in der Halbleiterschichtenfolge erzeugten elektromagnetischen Strahlung in diese zurück und in Richtung des Glassubstrats reflektiert.

Eine dem Glassubstrat zugewandte Hauptfläche des Halbleiterelements ist bei einer Ausgestaltung des Bauelements frei von elektrischen Anschlussflächen, auch Kontakte oder Kontaktflächen genannt. Zwei elektrische Anschlussflächen, die zur n-seitigen und zur p-seitigen Kontaktierung des Halbleiterelements vorgesehen sind, sind an einer von dem Glassubstrat abgewandten Seite des Halbleiterelements angeordnet.

Gemäß einer Weiterbildung des strahlungsemittierenden halbleiterbasierten Bauelements ist vorgesehen, auf der zweiten Oberfläche des Glassubstrates ein optisches Element anzuordnen. Somit werden die emittierten Strahlen des Halbleiterelements durch das Glassubstrat hindurch und ebenfalls durch das optische Element hindurch emittiert. Mit dem optischen Element lassen sich, je nach Verwendungszweck des strahlungsemittierenden halbleiterbasierten Bauelements und abhängig von den optischen Eigenschaften des optischen Elements verschiedene Wirkungen erzielen. Mit einem optischen Element, zum Beispiel ausgebildet als eine Linse, lässt sich ein gebündelter Strahl bilden. Mit einem optischen Element, ausgebildet als optischer Diffusor lässt sich die emittierte Strahlung streuen. Abhängig von der jeweiligen Verwendung des halbleiterbasierten Bauelementes lassen sich so verschiedene Eigenschaften ausbilden. Ein derart ausgebildetes strahlungsemittierendes halbleiterbasiertes Bauelement ist in Bezug auf dessen Größe frei skalierbar. Die erforderlichen Breiten- und Höhemaße orientieren sich im Wesentlichen an den gewünschten optischen Eigenschaften.

Zur Erzeugung von vorbestimmten Lichtfarben, beziehungsweise von vorbestimmten Wellenlängen der durch das halbleiterbasierte Bauelement emittierten Strahlung und insbesondere von mischfarbigem Licht, ist gemäß einer Weiterbildung des halbleiterbasierten Bauelements, zwischen dem strahlungsemittierenden Halbleiterelement und der ersten Oberfläche des Glassubstrates eine Konversionsschicht angeordnet. Eine Konversionsschicht wandelt die Wellenlänge der durch sie hindurch tretenden Strahlen zumindest für einen Teil der Strahlen. So lassen sich Farbtöne bilden die alleine durch die Strahlungsemission des Halbleiterelements nicht erzeugbar sind. So lässt sich zum Beispiel auf einfache und kostengünstige Weise weißes Licht erzeugen, indem ein Halbleiterelement welches blaues Licht emittiert, mit einer gelben Konversionsschicht kombiniert wird.

Es ist vorgesehen, das Glassubstrat bezogen auf dessen erste Oberfläche größer auszubilden als dies zur Aufnahme des Halbleiterelementes erforderlich wäre und dabei zusätzlich mehrere Montagesockel vorzusehen. Jeder der Montagesockel weist eine Materialstärke auf, welche der Gesamtdicke des Halbleiterelements gleicht und ist ausgebildet, mechanische Belastungen, welche auf das Glassubstrat beziehungsweise auf das halbleiterbasierte Bauelement wirken, aufzunehmen und an den Montageort abzuleiten. Damit ist, in einem eingebauten Zustand, das Halbleiterelement von mechanischen Belastungen rundum geschützt. Ein weiterer Vorteil dieser Anordnung ist dadurch gegeben, dass auch in einem nicht eingebauten Zustand, das Halbleiterelement vor abrasiven Belastungen etwas geschützt ist.

Gemäß einer Weiterbildung des halbleiterbasierten Bauelements mit strahlungsemittierenden Eigenschaften ist vorgesehen, zur Vermeidung von Streulichtverlusten die von dem Halbleiterelement nicht bedeckten Flächen durch einen Spiegel zu bedecken. Dieser ist bei einer Ausgestaltung direkt auf der ersten Oberfläche des Glassubstrates aufgebracht und bedeckt lediglich die von dem Halbleiterelement nicht bedecken Bereiche der ersten Oberfläche. Somit sind, von fertigungstechnisch bedingten Ausnahmen abgesehen, auf dem Glassubstrat entweder strahlungsemittierende Flächen, oder strahlungsreflektierende Flächen ausgebildet. Wobei die strahlungsemittierenden Flächen durch das Halbleiterelement gebildet sind und die strahlungsreflektierenden Flächen, durch den Spiegel gebildet sind.

Weiter wird ein Trägersubstrat angegeben, das vorgesehen ist, das halbleiterbasierte Bauelement aufzunehmen, welches gemäß dem vorstehend beschriebenen Prinzip ausgebildet ist.

Das Trägersubstrat weist dabei zwei elektrische Kontakte auf, die beschaltbar ausgeführt sind. Somit sind elektrische Signale beziehungsweise ist elektrische Energie einem von dem Trägersubstrat aufgenommenen halbleiterbasiertem Bauelement zuführbar. In Größe und flächiger Ausbildung sind die elektrischen Kontakte bei einer Ausgestaltung gleich den Kontaktelementen des Halbleiterelementes ausgeführt. So ist durch Kleben mit einem leitfähigen Klebstoff, oder durch Löten, ein elektrischer Kontakt zwischen dem Halbleiterelement und dem Trägersubstrat herstellbar. Die Kontaktelemente sind umgeben mit zumindest einer Sockelaufnahme, auf der der zumindest eine Montagesockel aufnehmbar ist. Die Sockelaufnahme ist elektrisch neutral und bildet demzufolge keine elektrische Verbindung mit den elektrischen Kontakten.

Weiter wird ein Verfahren zur Herstellung eines halbleiterbasierten Bauelementes angegeben. Das Verfahren umfasst die folgenden Schritte.

Ein Schritt umfasst ein Bereitstellen eines Glassubstrats. Ein drauffolgender zweiter Schritt umfasst das Aufbringen eines Halbleiterelementes auf einer ersten Oberfläche und das Aufbringen eines optischen Elementes auf einer zweiten Oberfläche des Glassubstrats.

Das Verfahren lässt sich auf eine Vielzahl von Glassubstraten gleichzeitig anwenden, wobei ein Glaswafer vorgesehen ist, auf dem parallel eine Vielzahl von Halbleiterbasierten Bauelementen gebildet wird. Ein Verfahrensschritt umfasst dann das Vereinzeln der halbleiterbasierten Bauelemente des gesamten Glaswafers.

Eine Weiterbildung des Verfahrens sieht vor, ein halbleiterbasiertes Bauelement mit strahlungsemittierenden Eigenschaften herzustellen, welches Strahlung einer vorbestimmten Wellenlänge oder mischfarbiges Licht, wie zum Beispiel weißes Licht, emittiert. Beispielsweise um Wellenlängen zu erzeugen, welche mittels bekannter Halbleiterwerkstoffe alleine nicht erzeugbar sind, wird gemäß einer Weiterbildung vor dem Aufbringen des Halbleiterelementes eine Konversionsschicht auf die erste Oberfläche des Glassubstrats aufgebracht. Dabei findet bevorzugt ein Siebdruckverfahren oder ein Schablonendruckverfahren Anwendung.

Für ein Halbleiterelement, dessen flächige Ausdehnung kleiner ist als die erste Oberfläche des Glassubstrats, ist vorgesehen eine Spiegelschicht aufzubringen, die mittels eines fototechnisch beeinflussten Sputter- oder Bedampfverfahren aufgebracht wird. Dabei wird die erste Oberfläche des Glassubstrats fototechnisch, insbesondere mittels eine fotolithografischen Prozesses, vorbehandelt, so dass lediglich die Bereiche mittels des Sputter- oder Bedampfverfahrens behandelbar sind, welche von dem Halbleiterelement und einer eventuell aufzubringenden Konversionsschicht unbedeckt bleiben.

Auf der zweiten Oberfläche des Glassubstrats wird das optische Element in eine alterungs- und temperaturstabile Schicht, bevorzugt aus Silikon eingebracht.

Nachfolgend wird die Erfindung anhand zweier Ausführungsbeispiele und unter Zuhilfenahme von 12 Figuren näher erläutert.

Es zeigt die
- Figur 1: das halbleiterbasierte Bauelement in einer ersten Ausführungsform in einer schematischen Querschnittsdarstellung,
- Figur 2: das halbleiterbasierte Bauelement in einer Abwandlung in schematischer perspektivischer Darstellung,
- Figur 3: das halbleiterbasierte Bauelement der ersten Ausführungsform in schematischer perspektivischer Darstellung,
- Figur 4: das halbleiterbasierte Bauelement der ersten Ausführungsform in schematischer perspektivischer Darstellung,
- Figur 5: einen Ausschnitt eines Trägersubstrats für das halbleiterbasierte Bauelement gemäß der ersten Ausführungsform in einer schematischen perspektivischen Darstellung,
- Figur 6: das halbleiterbasierte Bauelement gemäß der ersten Ausführungsform auf dem Trägersubstrat in einer schematischen perspektivischen Darstellung, und
- Figuren: 7 bis 12 schematische perspektivische Darstellungen einzelner Verfahrensschritte eines Ausführungsbeispiels eines Verfahrens zur Herstellung des halbleiterbasierten Bauelement der ersten Ausführungsform.

Figurübergreifend werden Elemente mit gleichen Funktionen mit gleichen Bezugszeichen versehen. Die Figuren und die Größenverhältnisse der in den Figuren dargestellten Elemente untereinander sind nicht als maßstäblich zu betrachten. Vielmehr können einzelne Elemente zur besseren Darstellbarkeit und/oder zum besseren Verständnis übertrieben groß dargestellt sein.

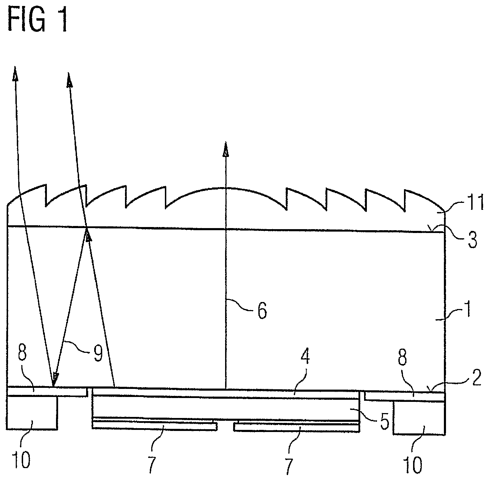

Figur 1 zeigt ein Ausführungsbeispiel eines halbleiterbasierenden Bauelementes mit strahlungsemittierenden Eigenschaften gemäß dem vorstehend beschriebenen Prinzip. Dabei ist als tragendes Element ein transparentes Glassubstrat 1 vorgesehen. Dieses Glassubstrat 1 weist eine erste Oberfläche 2 und eine zweite Oberfläche 3 auf. Auf der ersten Oberfläche 2 ist eine Konversionsschicht 4 aufgebracht, auf welcher ein Halbleiterelement 5 aufgenommen ist. Das Halbleiterelement 5 weist strahlungsemittierende Eigenschaften auf und ist derart auf der Konversionsschicht 4 angeordnet, dass die Strahlungsrichtung 6 durch die Konversionsschicht 4 hindurch und ebenso durch das Glassubstrat 1 hindurch gerichtet ist.

Bevorzugt ist das Halbleiterelement 5 als Dünnfilm-Leucht-Diode ausgeführt und umfasst an der vom Glassubstrat 1 abgewandten Oberfläche zumindest zwei elektrisch leitende Kontaktflächen 7 über die das Halbleiterelement 5 mit elektrischer Energie versorgt wird. Das Halbleiterelement 5 bedeckt bei dem dargestellten Ausführungsbeispiel nicht die gesamte erste Oberfläche 2 des Glassubstrates 1. Die verbleibenden Bereiche der ersten Oberfläche 2 des Glassubstrates 1 sind mit einem Spiegel 8 bedeckt. Der Spiegel 8 bewirkt, dass Streulichtanteile 9, welche durch Reflektion in Richtung der ersten Oberfläche 2 zurückgeleitet werden, an dem Spiegel 8 ebenso wieder in die Strahlrichtung 6 und damit in Richtung der zweiten Oberfläche 3 geleitet werden. Somit ist Streulichtverlust vermindert.

An den äußeren Rändern der ersten Oberfläche 2 sind Montagesockel 10 ausgebildet, durch welche das halbleiterbasierte Bauelement auf einem Trägersubstrat stabil festgelegt werden kann. Die Montagesockel 10 sind dergestalt ausgeführt, dass das gesamte halbleiterbasierte Bauelement durch die Montagesockel 10 an dem Einbauort getragen ist. So sind mechanische Belastungen am Halbleiterelement 5 vermieden.

Auf der zweiten Oberfläche 3 des Glassubstrats 1 ist ein optisches Element 11 aufgenommen. Das Ausführungsbeispiel zeigt das optische Element 11 in Form einer Fresnellinse. Mittels des optischen Elements 11 in Form einer Fresnellinse ist ein gebündelter Strahl erzeugbar. Das halbleiterbasierte Bauelement ist aber nicht auf dieses Ausführungsbeispiel begrenzt, vielmehr sind optische Elemente mit anderen Eigenschaften verwendbar, wie zum Beispiel ein optischer Diffusor. Dies ist lediglich abhängig von dem Verwendungszweck des halbleiterbasierten Bauelements.

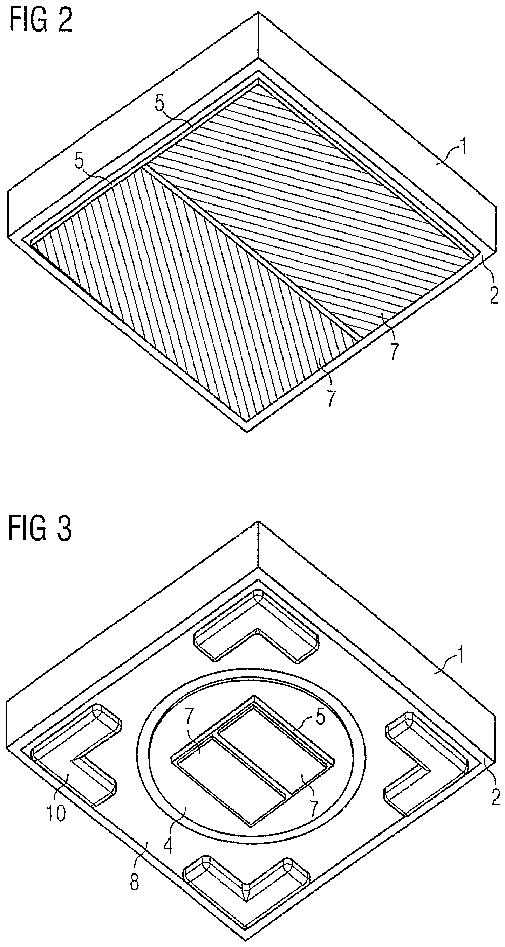

Die Figur 2 zeigt das halbleiterbasierte Bauelement mit strahlungsemittierenden Eigenschaften in einer Abwandlung, bei der das Halbleiterelement 5 nahezu die gesamte erste Oberfläche 2 des Glassubstrates 1 einnimmt. Diese Ausführungsform ist gebildet, wenn das Glassubstrat 1 und dessen flächige Ausdehnung an der ersten Oberfläche 2, nahezu der flächigen Ausdehnung des Halbleiterelements 5 entspricht. Im Gegensatz zu dem ersten Ausführungsbeispiel aus der Figur 1 ist in diesem Ausführungsbeispiel die Anordnung von Montagesockeln 10 oder die Anordnung eines Spiegels 8 nicht erforderlich.

Die Figur 3 zeigt das erste Ausführungsbeispiel des halbleiterbasierten Bauelements in einer perspektivischen Darstellung. Die Blickrichtung ist auf die erste Oberfläche 2 des halbleiterbasierten Bauelementes gerichtet.

Auf dieser Oberfläche sind das Halbleiterelement 5, die Konversionsschicht 4, der Spiegel 8 und die Montagesockel 10 angeordnet. Mittig auf der ersten Oberfläche 2 des Glassubstrats 1 ist einer kreisrunden Form folgend, die Konversionsschicht 4 angeordnet, auf welcher das Halbleiterelement 5 bevorzugt mittig angeordnet ist. Das Halbleiterelement 5 weist seinerseits elektrisch leitende Kontaktflächen 7 auf, die vorgesehen sind an einem Einbauort das Halbleiterelement 5 mit elektrischer Energie zu versorgen. Die kreisrunde Konversionsschicht 4 umgebend, ist ein Spiegel 8 aufgebracht, zur Verminderung von Streulichtverlusten.

Das Glassubstrat 1 ist bevorzugt in einer quadratischen Grundform ausgeführt und umfasst zumindest einem Montagesockel 10 in jedem Eckbereich der ersten Oberfläche 2 des Glassubstrats 1. Mittels der Montagesockel 10 wird das halbleiterbasierte Bauelement an einem Einbauort fixiert. Dabei werden mechanische Kräfte, die auf das halbleiterbasierte Bauelement an einem Einbauort wirken über die Montagesockel 10 abgeleitet, so dass das Halbleiterelement 5 vor mechanischer Belastung geschützt ist. Das in der Figur 3 dargestellte halbleiterbasierte Bauelement hat eine im Wesentlichen quadratische Grundform mit einer Kantenlänge von im Wesentlichen 3 mm und eine Dicke von im Wesentlichen 0,85 mm. Das vorstehende beschriebene Prinzip ist jedoch nicht auf diese äußeren Abmessungen begrenzt. Vielmehr ist einer der Vorteile darin zu sehen, dass die Größe eines einzelnen halbleiterbasierten Bauelementes nach dem vorstehend beschriebenen Prinzip lediglich durch die Anforderungen an die optischen Eigenschaften bestimmt ist.

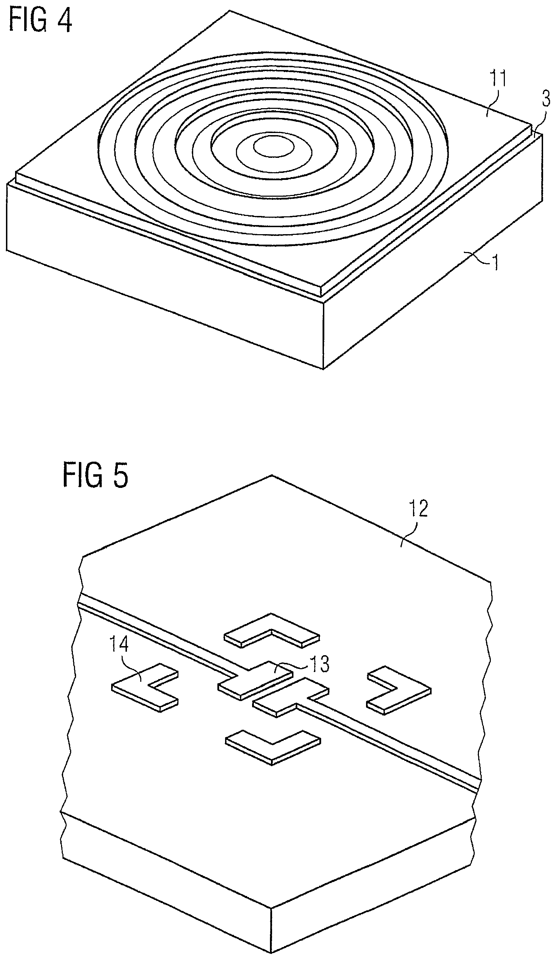

Die Figur 4 zeigt das erste Ausführungsbeispiel welches auch in der Figur 1 und der Figur 3 gezeigt ist in einer perspektivischen Darstellung. Die Blickrichtung in dieser Darstellung ist auf die zweite Oberfläche 3 des Glassubstrats 1 gerichtet. Auf der zweiten Oberfläche 3 ist das optische Element 11 aufgenommen. Im Ausführungsbeispiel ist das optische Element 11 gemäß einer Linse ausgeführt. Das Ausführungsbeispiel zeigt eine Fresnellinse.

Figur 5 zeigt ein Ausführungsbeispiel eines Trägersubstrats für ein halbleiterbasiertes Bauelement gemäß den Ausführungsbeispielen aus den Figuren 1, 3 oder 4, bei dem auf einer Leiterplatte 12 zumindest zwei elektrisch leitenden Kontakte 13 angeordnet sind. Diese Kontakte sind mittels zuführender Leiterbahnen mit elektrischen Signalen oder elektrischer Energie beschaltbar. Damit ist eine Beschaltung der elektrischen Kontakte 7 des Halbleiterelementes 5 in einem montierten Zustand des halbleiterbasierten Bauelementes möglich. Das halbleiterbasierte Bauelement und das Trägersubstrat sind auf einander abgestimmt, so dass die elektrischen Kontaktflächen 7 des Halbleiterelements 5 mit den elektrischen Kontakten 13 zusammenwirken. An dem Trägersubstrat sind Sockelaufnahmen 14 angeordnet, die mit den Montagsockeln 10 des halbleiterbasierten Bauelements zusammenwirken. Demzufolge sind die elektrischen Kontakte 13 auf dem Trägersubstrat mittig angeordnet und sind von Sockelaufnahmen 14 so umgeben, dass jeder Montagesockel 10 auf einer Sockelaufnahme 14 durch einen Klebevorgang oder einen Lötvorgang oder andere kraftschlüssige Verfahren aufnehmbar ist.

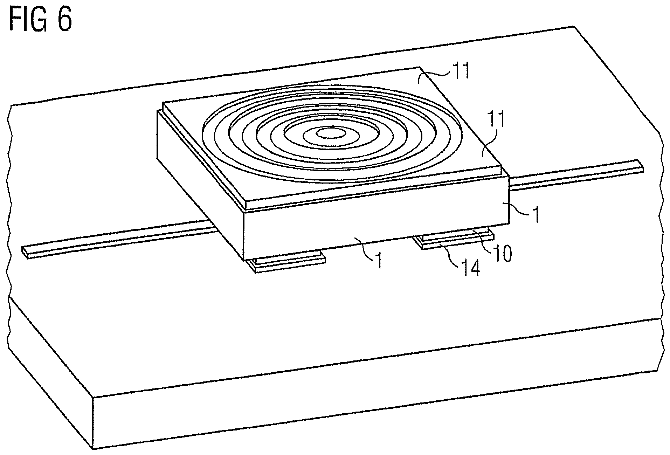

Ein auf dem Trägersubstrat angeordnetes halbleiterbasiertes Bauelement zeigt die Figur 6 in einer perspektivischen Darstellung. Dort ist gezeigt, dass jeder Montagesockel 10 auf je einer Sockelaufnahme 14 angeordnet ist.

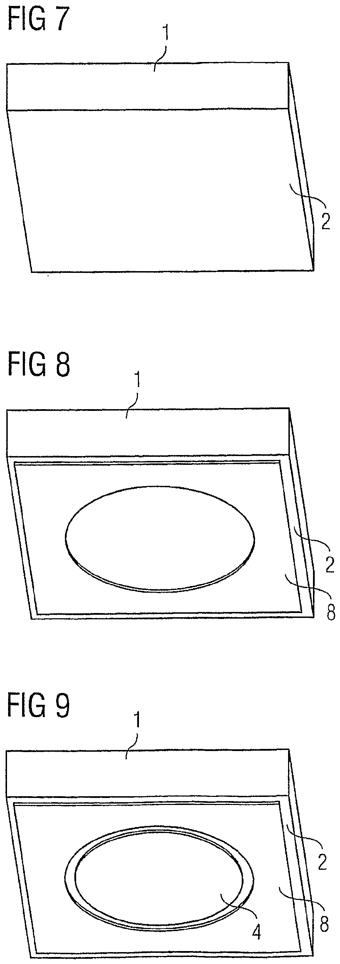

Die Figuren 7 bis 12 beschreiben in einzelnen Verfahrensschritten ein Herstellungsverfahren am Beispiel eines einzelnen halbleiterbasierten Bauelements gemäß dem vorstehend beschriebenen Prinzip und gemäß dem vorstehend beschriebenen ersten Ausführungsbeispiel.

In Figur 7 ist ein transparentes Glassubstrat 1 gezeigt, das eine quadratischen Grundform aufweist. Das beschreibt bereits die Form, welche ein einzelnes halbleiterbasiertes Bauelement aufweist. Insbesondere sind die lateralen Abmessungen des Bauelements gleich den lateralen Abmessungen des Glassubstrats.

Ein optimiertes Produktionsverfahren zur Herstellung vorstehend beschriebener halbleiterbasierter strahlungsemittierender Bauelemente sieht vor, eine Vielzahl von solchen Glassubstraten gleichzeitig auf einem Glaswafer zu bearbeiten. Der Glaswafer wird dann in einem vorbestimmten Teilschritt des Herstellungsverfahrens vereinzelt, so dass einzelne Elemente gebildet sind. Zum besseren Verständnis des Herstellungsverfahrens ist das Verfahren anhand eines einzelnen Elements gezeigt.

Ausgehend von dem Glassubstrat 1 wird, dargestellt in Figur 8, durch einen Sputterprozess oder einen Aufdampfprozess eine Spiegelschicht zur Bildung des Spiegels 8 an der ersten Oberfläche 2 des Glassubstrats 1 aufgebracht. Diesem Prozess ist ein fotolithografisches Verfahren vorangestellt um Oberflächenbereiche zu definieren, welche keine Spiegelbeschichtung erhalten sollen.

Anschließend wird, gezeigt in Figur 9, auf die erste Oberfläche 2 des Glassubstrats 1, beispielsweise auf einen Teilbereich der ersten Oberfläche 2, eine Konversionsschicht 4 aufgebracht. Die Konversionsschicht 4 wird mittels eines Siebdruck- oder Schablonendruckverfahrens aufgebracht. Vorliegend wird ein von dem Spiegel 8 unbedeckter Mittelbereich der ersten Oberfläche 2 mit der Konversionsschicht 4 beschichtet. Der Spiegel 8 ist von der Konversionsschicht 8 vorliegend unbedeckt.

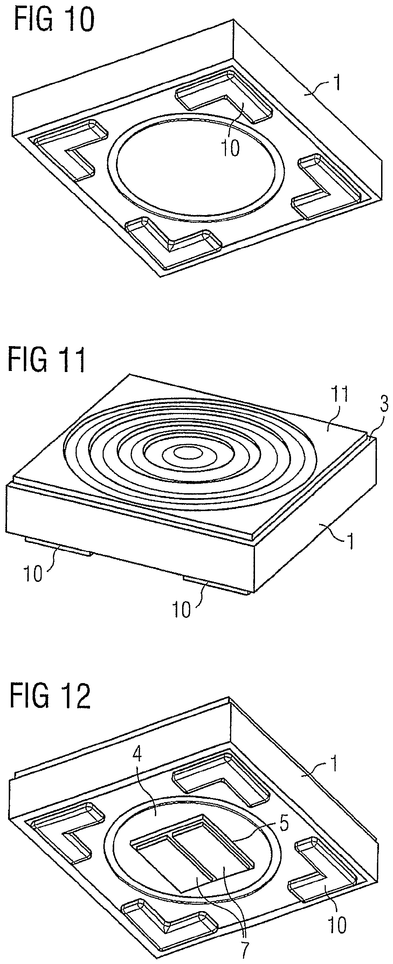

Anschließend erfolgt, gezeigt in Figur 10, mittels eines - beispielsweise fotolithografisch unterstützten - galvanischen Prozesses das Aufbringen der Montagesockel 10, jeweils an den Eckbereichen des Glassubstrats 1. Die Montagesockel 8 werden beispielsweise auf Randbereiche des Spiegels 8 aufgebracht.

In einem nachfolgenden Verfahrensschritt, dargestellt in Figur 11, wird nunmehr die zweite Oberfläche 3 mit dem optischen Element 10 versehen. Das optische Element 10 wird dabei in eine alterungs- und temperaturstabile Schicht zum Beispiel aus Silikon eingebracht.

Der in Figur 12 dargestellte Arbeitsschritt umfasst das Aufbringen des Halbleiterelements 5 auf die Konversionsschicht 4. Das Halbleiterelement 5, welches als Dünnfilm-Leucht-Diode ausgebildet ist, umfasst bereits Kontaktflächen 7 zum Anschluss und zur Bildung eines elektrischen Kontakts für die elektrische Energieversorgung des Halbleiterelements. Die Dünnfilm-Leucht-Diode ist in einem weiteren Herstellungsverfahren produziert und wird bei dem zuletzt beschriebenen Verfahrensschritt auf dem Glassubstrat 1 angeordnet.

## Patentansprüche

1. Halbleiterbasiertes Bauelement zur Montage auf einem Trägersubstrat mit
- einem Glassubstrat (1), welches eine erste Oberfläche (2) und eine zweite Oberfläche (3), die der ersten Oberfläche (2) gegenüber liegt, aufweist,
- einem Halbleiterelement (5) mit strahlungsemittierenden Eigenschaften, das auf der ersten Oberfläche (2) angeordnet ist, wobei das Halbleiterelement (5) zumindest zwei elektrisch leitende Kontaktflächen (7) an der von der ersten Oberfläche (2) des Glassubstrats (1) abgewandten Seite aufweist,
- eine Mehrzahl von galvanisch aufgebrachten Montagesockeln (10) auf dem Randbereich der ersten Oberfläche (2) des Glassubstrats (1),
wobei
- die Kontaktflächen (7) so eingerichtet sind, dass sie durch Kleben mit einem leitfähigen Klebstoff oder durch Löten mit Kontakten des Trägersubstrats elektrisch leitend verbindbar sind,
- die Montagesockel (10) von den Kontaktflächen (7) verschieden sind und eine Materialstärke aufweisen, welche der Gesamtdicke des Halbleiterelements (5) gleicht, sodass die Montagesockel (10) das Bauelement im unmontierten Zustand vor abrasiver Belastung schützen und im montierten Zustand mechanische Belastungen aufnehmen und an das Trägersubstrat ableiten können,
- die Kontaktflächen (7) im unmontierten Zustand frei liegen.

2. Halbleiterbasiertes Bauelement nach Patentanspruch 1,
**dadurch gekennzeichnet, dass**
auf der zweiten Oberfläche (3) ein optisches Element (11) aufgenommen ist.

3. Halbleiterbasiertes Bauelement nach einem der Patentansprüche 1 oder 2,
**dadurch gekennzeichnet, dass**
zwischen der ersten Oberfläche (2) und dem strahlungsemittierenden Halbleiterelement (5) eine Konversionsschicht (4) angeordnet ist.

4. Halbleiterbasiertes Bauelement nach mindestens Patentanspruch 2,
**dadurch gekennzeichnet, dass** das optische Element die Form einer Fresnellinse aufweist,
oder dass das optische Element (11) als optischer Diffusor ausgebildet ist.

5. Halbleiterbasiertes Bauelement nach einem der vorhergehenden Patentansprüche,
**dadurch gekennzeichnet, dass**
nicht die gesamte erste Oberfläche (2) von dem Halbleiterelement (5) bedeckt ist, und dass verbleibende Bereiche der ersten Oberfläche (2) von einem Spiegel (8) bedeckt sind.

6. Halbleiterbasiertes Bauelement nach den Patentansprüchen 3 und 5,
**dadurch gekennzeichnet, dass**
ein von dem Spiegel (8) unbedeckter Mittelbereich der ersten Oberfläche (2) mit der Konversionsschicht (4) beschichtet ist, wobei die Konversionsschicht (4) von dem Spiegel (8) unbedeckt ist.

7. Halbleiterbasiertes Bauelement nach dem vorhergehenden Patentanspruch,
**dadurch gekennzeichnet, dass**
die Konversionsschicht (4) kreisrund geformt ist und das transparente Glassubstrat (1) eine quadratische Grundform aufweist.

8. Halbleiterbasiertes Bauelement nach dem vorhergehenden Patentanspruch,
**dadurch gekennzeichnet, dass**
das Halbleiterelement (5) mittig auf der ersten Oberfläche (2) angeordnet und von den Montagesockeln (10) umgeben ist.

9. Halbleiterbasiertes Bauelement nach einem der vorhergehenden Patentansprüche,
**dadurch gekennzeichnet, dass**
das Glassubstrat (1) ein tragendes Element des halbleiterbasierten Bauelements ist.

10. Halbleiterbasiertes Bauelement nach einem der vorhergehenden Patentansprüche,
**dadurch gekennzeichnet, dass**
das Halbleiterelement (5) eine Dünnfilm-Leuchtdiode ist, die, ohne das Glassubstrat (1), eine Dicke von 20 µm oder weniger aufweist.

11. Halbleiterbasiertes Bauelement nach dem vorhergehenden Patentanspruch,
**dadurch gekennzeichnet, dass**
an einer dem Glassubstrat (1) abgewandten Hauptfläche des Halbleiterelements (5) eine reflektierende Schicht aufgebracht oder ausgebildet ist, die zumindest einen Teil der in dem Halbleiterelement (5) erzeugten elektromagnetischen Strahlung in dieses zurück und in Richtung des Glassubstrats (1) reflektiert.

12. Halbleiterbasiertes Bauelement nach mindestens Patentanspruch 2,
**dadurch gekennzeichnet, dass**
das optische Element (10) in eine alterungsstabile und temperaturstabile Schicht aus Silikon eingebracht ist.

13. Verfahren zur Herstellung eines halbleiterbasiertes Bauelements nach einem der vorhergehenden Patentansprüche, mit folgenden Schritten:
- Bereitstellen eines Glassubstrats (1),
- Aufbringen eines Halbleiterelements (5) auf einer ersten Oberfläche (2) des Glassubstrats (1).

## Claims

1. Semiconductor based component for mounting on a carrier substrate, comprising
- a glass substrate (1), which comprises a first surface (2) and a second surface (3), which lies opposite the first surface (2),
- a semiconductor element (5) with radiation-emitting properties, which is arranged on the first surface (2), wherein the semiconductor element (5) comprises at least two electrically conductive contact areas (7) on the side facing away from the first surface (2) of the glass substrate (1),
- a plurality of electroplated mounting bases (10) on the peripheral area of the first surface (2) of the glass substrate (1),
wherein
- the contact surfaces (7) are configured such that they are electrically-conductively connectable by bonding with a conductive adhesive or by soldering with contacts of the carrier substrate,
- the mounting bases (10) are distinct from the contact surfaces (7) and have a material thickness which equals the total thickness of the semiconductor element (5), so that the mounting bases (10) protect the component from abrasive stress in the unmounted state, and can absorb mechanical stresses in the mounted state and can divert them to the carrier substrate,
- the contact surfaces (7) are exposed in the unmounted state.

2. Semiconductor based component according to claim 1,
**characterized in that**
on the second surface (3), an optical element (11) is received.

3. Semiconductor based component according to one of the claims 1 or 2,
**characterized in that**
between the first surface (2) and the radiation-emitting semiconductor element (5), a conversion layer (4) is arranged.

4. Semiconductor based component according to at least claim 2,
**characterized in that** the optical element comprises the form of a Fresnel lens,
or **in that** the optical element (11) is formed as optical diffuser.

5. Semiconductor based component according to one of the preceding claims,
**characterized in that**
not the entire first surface (2) is covered by the semiconductor element (5), and **in that** remaining areas of the first surface (2) are covered by a mirror (8).

6. Semiconductor based component according to the claims 3 and 5,
**characterized in that**
a central area of the first surface (2) not covered by the mirror (8) is coated with the conversion layer (4), wherein the conversion layer (4) is not covered by the mirror (8).

7. Semiconductor based component according to the preceding claim,
**characterized in that**
the conversion layer (4) is circular in shape, and the transparent glass substrate (1) has a square base shape.

8. Semiconductor based component according to the preceding claim,
**characterized in that**
the semiconductor element (5) is arranged centrally on the first surface (2) and surrounded by the mounting bases (10).

9. Semiconductor based component according to one of the preceding claims,
**characterized in that**
the glass substrate (1) is a load-bearing element of the semiconductor based component.

10. Semiconductor based component according to one of the preceding claims,
**characterized in that**
the semiconductor element (5) is a thin-film light-emitting diode, which, without the glass substrate (1), has a thickness of 20 µm or less.

11. Semiconductor based component according to the preceding claim,
**characterized in that**
a reflective layer is applied or formed on a main surface of the semiconductor element (5) facing away from the glass substrate (1), which reflects at least a part of the electromagnetic radiation generated in the semiconductor element (5) back therein and in direction of the glass substrate (1).

12. Semiconductor based component according to at least claim 2,
**characterized in that**
the optical element (10) is incorporated in an age-resistant and temperature-stable layer of silicone.

13. Method for producing a semiconductor based component according to one of the preceding claims, comprising the following steps:
- providing a glass substrate (1),
- applying a semiconductor element (5) on a first surface (2) of the glass substrate (1).

## Revendications

1. Composant à base de semi-conducteur, destiné au montage sur un substrat porteur, comprenant
- un substrat de verre (1), lequel présente une première surface (2) et une deuxième surface (3) qui est située à l'opposé de la première surface (2),
- un élément semi-conducteur (5) doté de caractéristiques émettrices de rayonnement, lequel est disposé sur la première surface (2), l'élément semi-conducteur (5) présentant sur le côté détourné de la première surface (2) du substrat de verre (1) au moins deux surfaces de contact (7) électroconductrices,
- une pluralité de socles de montage (10) placés galvaniquement sur la partie de bord de la première surface (2) du substrat de verre (1), dans lequel
- les surfaces de contact (7) étant conçues de manière à ce qu'elles puissent être reliées à des contacts du substrat porteur de manière électro-conductrice par collage avec une colle conductrice ou par soudage,
- les socles de montage (10) étant différents des surfaces de contact (7) et présentant une épaisseur de matière qui est égale à l'épaisseur totale de l'élément semi-conducteur (5), de sorte que les socles de montage (10) protègent le composant contre une charge abrasive à l'état non monté et, à l'état monté, peuvent absorber des charges mécaniques et les dériver sur le substrat porteur,
- les surfaces de contact (7) étant à découvert à l'état non monté.

2. Composant à base de semi-conducteur selon la revendication 1,
**caractérisé en ce qu'**
un élément optique (11) est logé sur la deuxième surface (3).

3. Composant à base de semi-conducteur selon l'une quelconque des revendications 1 ou 2,
**caractérisé en ce qu'**
une couche de conversion (4) est disposée entre la première surface (2) et l'élément semi-conducteur (5) émetteur de rayonnement.

4. Composant à base de semi-conducteur selon au moins la revendication 2,
**caractérisé en ce que** l'élément optique présente la forme d'une lentille de Fresnel,
ou **en ce que** l'élément optique (11) est réalisé comme diffuseur optique.

5. Composant à base de semi-conducteur selon l'une quelconque des revendications précédentes,
**caractérisé en ce que**
l'élément semi-conducteur (5) ne recouvre pas la totalité de la première surface (2), et **en ce que** des parties restantes de la première surface (2) sont recouvertes par un miroir (8).

6. Composant à base de semi-conducteur selon les revendications 3 et 5,
**caractérisé en ce qu'**
une partie centrale de la première surface (2), non recouverte par le miroir (8), est revêtue de la couche de conversion (4), la couche de conversion (4) n'étant pas recouverte par le miroir (8).

7. Composant à base de semi-conducteur selon la revendication précédente,
**caractérisé en ce que**
la couche de conversion (4) est formée de manière circulaire et **en ce que** le substrat de verre (1) transparent présente une forme de base carrée.

8. Composant à base de semi-conducteur selon la revendication précédente,
**caractérisé en ce que**
l'élément semi-conducteur (5) est disposé au milieu de la première surface (2) et est entouré par les socles de montage (10).

9. Composant à base de semi-conducteur selon l'une quelconque des revendications précédentes,
**caractérisé en ce que**
le substrat de verre (1) est un élément porteur du composant à base de semi-conducteur.

10. Composant à base de semi-conducteur selon l'une quelconque des revendications précédentes,
**caractérisé en ce que**
l'élément semi-conducteur (5) est diode électroluminescente à couche mince qui, sans le substrat de verre (1), présente une épaisseur de 20 µm ou moins.

11. Composant à base de semi-conducteur selon la revendication précédente,
**caractérisé en ce que**
sur une surface principale de l'élément semi-conducteur (5), détournée du substrat de verre (1), est placée ou réalisée une couche réfléchissante qui réfléchit au moins une partie du rayonnement électromagnétique généré dans l'élément semi-conducteur (5) en retour dans celui-ci et en direction du substrat de verre (1).

12. Composant à base de semi-conducteur selon au moins la revendication 2,
**caractérisé en ce que**
l'élément optique (11) est placé dans une couche en silicone résistante au vieillissement et stable en température.

13. Procédé de fabrication d'un composant à base de semi-conducteur selon l'une quelconque des revendications précédentes, comprenant les étapes suivantes :
- fourniture d'un substrat de verre (1),
- placement d'un élément semi-conducteur (5) sur une première surface (2) du substrat de verre (1).
